# EUROPÄISCHE PATENTSCHRIFT

(11) **EP 3 774 432 B1**
(45) Veröffentlichungstag und Bekanntmachung des Hinweises auf die Patenterteilung: **02.03.2022**
(21) Anmeldenummer: 19722516.2
(22) Anmeldetag: 11.04.2019
(51) Int. Cl.: B60K 35/00, B60K 37/06, G06F 3/042, H03K 17/94, H03K 17/96

(54) **ANZEIGEVORRICHTUNG, INSBESONDERE FÜR EIN FAHRZEUG**
DISPLAY DEVICE, IN PARTICULAR FOR A VEHICLE
DISPOSITIF D'AFFICHAGE, EN PARTICULIER POUR UN VÉHICULE

(30) Priorität: 13.04.2018 DE 102018108853
(43) Veröffentlichungstag der Anmeldung: 17.02.2021
(73) Patentinhaber: Behr-Hella Thermocontrol GmbH, 59557 Lippstadt (DE)
(72) Erfinder: FUST, Winfried, 59557 Lippstadt (DE); SIEKKINEN, Tuomas, 59557 Lippstadt (DE); SCHWAB, Tobias, 59557 Lippstadt (DE); SCHMIDT, Rüdiger, 59557 Lippstadt (DE); SÁNCHEZ CASTILLO, Alberto, 59557 Lippstadt (DE)
(74) Vertreter: dompatent von Kreisler Selting Werner - Partnerschaft von Patent- und Rechtsanwälten mbB
(86) Internationale Anmeldenummer: PCT/EP2019/059234
(87) Internationale Veröffentlichungsnummer: WO 2019/197525

(56) Entgegenhaltungen:
- CN-A- 101 441 541
- US-A1- 2015 084 928
- US-B2- 8 860 694
- US-B2- 9 557 846

## Beschreibung

Die Erfindung betrifft eine Anzeigevorrichtung, die insbesondere eingesetzt wird für ein Fahrzeug.

Displays o.dgl. Anzeigevorrichtungen mit der zusätzlichen Funktionalität der Bedienbefehleingabe erfreuen sich insbesondere im Innenraum von Fahrzeugen zunehmender Beliebtheit. Derartige Anzeige-/Bediensysteme werden im zunehmenden Maße zusätzlich noch mit der Funktionalität der Erkennung einer Objektannäherung versehen, um beispielsweise die Anzeigevorrichtung für die Bedienbefehleingabe zu aktivieren oder verschiedene Bedienoberflächen in Abhängigkeit von der Annäherung eines Objekts, beispielsweise der Hand bzw. eines Fingers einer Person zu ändern. Dabei arbeitet eine derartige Näherungssensorik mit optischer Strahlung im nicht sichtbaren Wellenlängenbereich und insbesondere mit IR-Licht. Die Anzeigevorrichtung selbst ist versehen mit einer Hinterleuchtungseinheit zur Hinterleuchtung des Displays mit sichtbarem Licht.

Zur Reduktion der Bautiefe derartiger Anzeigevorrichtungen ist es bekannt, das Hinterleuchtungslicht seitlich in eine Lichtleiterplatte einzuspeisen, die sich hinter dem Display befindet. Die Sender- und Empfängerelemente für die optische Näherungssensorik befinden sich zumeist im Randbereich neben dem Display bzw. neben der sogenannten Active Area des Displays. Dieser Bereich steht aber auch nicht immer zur Verfügung, schränkt somit die Designfreiheit beim Entwurf einer Anzeigevorrichtung ein.

Aus dem Stand der Technik sind elektrische Anzeigenvorrichtungen, welche über ein Display mit LED-Hinterleuchtungslicht und eine Näherungssensorik verfügen, beispielsweise aus US-A-2018/0069609 bekannt. US-A-2015/0084928 offenbart eine Hinterleuchtungseinheit mittels Edge-Light Konzept. US-A-2015/0084928 zeigt eine elektrische Anzeigenvorrichtung, die mit einem Display und einem Näherungssensoriksystem ausgestattet ist.

Aus US-B-8 860 694 ist eine Anzeigevorrichtung nach dem Oberbegriff der Ansprüche 1 und 11 bekannt.

In US-B-9 557 846 ist eine optische Sensorik für eine Anzeige- und Bedienvorrichtung beschrieben, bei der die Veränderung der Reflektion von Detektionsstrahlung, die unter interner Totalreflektion in das Display der Vorrichtung eingebracht wird, dazu genutzt wird, um den Ort der Berührung des Displays durch einen Finger einer Person zu erkennen.

Aufgabe der Erfindung ist es, eine Anzeigevorrichtung, insbesondere für ein Fahrzeug, zu schaffen, die mit einer optischen Näherungssensorik versehen ist, welche platzsparend angeordnet ist.

Zur Lösung dieser Aufgabe wird gemäß einer ersten Alternative der Erfindung eine Anzeigevorrichtung, insbesondere für ein Fahrzeug vorgeschlagen, die versehen ist mit
- einem Display,
- einer Hinterleuchtungseinheit zum Hinterleuchten des Displays,
- wobei die Hinterleuchtungseinheit mehrere Lichtquellen für Hinterleuchtungslicht und eine Lichtleiterplatte mit einer dem Display zugewandten Lichtaustrittsseite, einer dieser gegenüberliegenden Rückseite und mit einer zwischen der Lichtaustrittsseite und der Rückseite angeordneten, umlaufenden Seitenrandfläche aufweist,
- wobei die Lichtquellen zwecks Einspeisung von Licht durch zumindest einen Teilbereich der Seitenrandfläche der Lichtleiterplatte in diese seitlich versetzt neben der Lichtleiterplatte angeordnet sind und seitlich in die Lichtleiterplatte eingespeistes Hinterleuchtungslicht aus der Lichtaustrittsseite der Lichtleiterplatte austritt und
- einer Näherungssensorik zum Sensieren eines sich im Bereich vor dem Display befindlichen Objekts wie z.B. eine Hand einer Person,
- wobei die Näherungssensorik mindestens ein Näherungssensorik-Senderelement zum Aussenden von nicht sichtbarer Sensorstrahlung, insbesondere IR-Sensorstrahlung, und mindestens ein Näherungssensorik-Empfangselement zum Empfangen von an einem Objekt im Bereich vor dem Display reflektierter Sensorstrahlung aufweist,
- wobei das mindestens eine Näherungssensorik-Senderelement seitlich versetzt zu einem Bereich der Seitenrandfläche der Lichtleiterplatte angeordnet ist und die Sensorstrahlung in diesem Bereich in die Seitenrandfläche der Lichtleiterplatte eingespeist sowie aus der Lichtaustrittsseite der Lichtleiterplatte austritt und
- wobei das mindestens eine Näherungssensorik-Empfangselement zwischen dem Display und der Lichtleiterplatte und/oder der Rückseite der Lichtleiterplatte gegenüberliegend angeordnet ist.

Die erfindungsgemäße Anzeigevorrichtung ist mit einem Display und mit einer hinter dem Display angeordneten Hinterleuchtungseinheit zum Hinterleuchten des Displays versehen. Diese Hinterleuchtungseinheit arbeitet nach dem sogenannten Edge-Light-Konzept, bei dem in eine Lichtleiterplatte seitlich Hinterleuchtungslicht eingespeist wird. Die Lichtleiterplatte befindet sich hinter dem Display und weist eine Lichtaustrittsseite, eine dieser Lichtaustrittsseite gegenüberliegende Rückseite und eine umlaufende Seitenrandfläche auf. Die Lichtquellen der Hinterleuchtungseinheit befinden sich der Seitenrandfläche gegenüberliegend angeordnet, so dass ihr Hinterleuchtungslicht über die Seitenrandfläche in die Lichtleiterplatte eingespeist wird, wo durch entsprechende Maßnahmen das Hinterleuchtungslicht intern zur Lichtaustrittsseite hin reflektiert wird und somit aus der Lichtaustrittsseite und anschließend durch das Display hindurch abgestrahlt wird.

Erfindungsgemäß wird nun bei der ersten Variante die Sensorstrahlung des mindestens einen Näherungssensorik-Senderelements ebenfalls in einen Teilbereich der Seitenrandfläche der Lichtleiterplatte eingespeist. In der Lichtleiterplatte wird diese Sensorstrahlung wie das Hinterleuchtungslicht zur Lichtaustrittsseite hin umgelenkt und durchdringt dann anschließend das Display und gelangt somit in den dem Display vorgelagerten Raum bzw. Bereich, um nach Reflektion an einem sich in diesem Bereich befindenden Objekt (Hand, Finger) von einem oder mehreren Näherungssensorik-Empfangselementen empfangen zu werden. Die Empfangssignale werden in einer Auswerteeinheit verarbeitet, die im Allgemeinen auch die Näherungssensorik-Senderelemente bzw. das mindestens eine Näherungssensorik-Senderelement ansteuert. Beispielsweise können bei mehreren Näherungssensorik-Senderelementen diese sequentiell bzw. zyklisch angesteuert werden, um dann über die über das Display verteilt angeordneten Näherungssensorik-Empfangselemente Empfangssignale zu empfangen, um damit wiederum detektieren zu können, in welchem Bereich vor dem Display sich gerade ein Objekt befindet. Somit kann die Objekterkennung mit einer gewissen durch die Dichte von Sender- und Empfangselementen der Näherungssensorik bestimmten Auflösung erfolgen.

Allgemein ist es von Vorteil, wenn an der Rückseite der Lichtleiterplatte ein das Hinterleuchtungslicht und die Sensorstrahlung reflektierender Reflektor angeordnet ist oder wenn die Rückseite der Lichtleiterplatte eine das Hinterleuchtungslicht oder die Sensorstrahlung reflektierende Reflektionsbeschichtung aufweist.

Im Regelfall wünscht man eine besonders intensive Ausleuchtung des Displays mit Hinterleuchtungslicht. Das bedeutet, dass längs der Seitenrandfläche der Lichtleiterplatte bereits Hinterleuchtungslichtquellen dicht an dicht angeordnet sind. Sofern also deshalb zwischen diesen Hinterleuchtungslichtquellen kein Platz mehr vorhanden ist für Näherungssensorik-Senderelemente, ist es zweckmäßig, diese Näherungssensorik-Senderelemente unter- oder oberhalb der Hinterleuchtungslichtquellen anzuordnen. Das bedeutet, dass die Lichtleiterplatte dicker auszuführen ist, so dass letztendlich zwei Reihen von Strahlungsquellen, nämlich einerseits die Hinterleuchtungslichtquellen und andererseits die Näherungssensorik-Senderelemente übereinander angeordnet werden können. Problematisch hierbei könnte allerdings die Herstellung der Lichtleiterplatte im Spritzguss sein, und zwar wegen der erforderlichen größeren Dicke der Lichtleiterplatte gegenüber dem zuvor vorgestellten ersten Ansatz des erfindungsgemäßen Konzepts gemäß der ersten Variante.

Insoweit von Vorteil ist es, wenn die Lichtleiterplatte eine obere Lichtleitermaterialschicht mit einer umlaufenden oberen Seitenrandfläche und eine untere Lichtleitermaterialschicht mit einer umlaufenden unteren Seitenrandfläche umfasst, wobei die Lichtquellen Hinterleuchtungslicht in zumindest einen Teilbereich der oberen Seitenrandfläche einspeisen und das mindestens eine Näherungssensorik-Senderelement Sensorstrahlung in zumindest einen Teilbereich der unteren Seitenrandfläche einspeist. Bei diesem Ansatz umfasst die Lichtleiterplatte also zwei Lichtleitermaterialschichten, die einstückig oder auch getrennt voneinander sind. Mit anderen Worten werden also zwei Lichtleiterplattenelemente eingesetzt. Jedes Lichtleiterplattenelement dient nun der Umlenkung unterschiedlicher Strahlung. So lenkt das obere Lichtleiterplattenelement das Hinterleuchtungslicht um, um es aus der dem Display zugewandten Lichtaustrittsseite der Lichtleiterplatte austreten zu lassen. Das untere Lichtleiterplattenelement empfängt die Sensorstrahlung und lenkt diese in Richtung Display um. Die Sensorstrahlung passiert damit auch die obere Lichtleitermaterialschicht, um alsdann aus dieser auszutreten. Der Vorteil der Verwendung zweier Lichtleiterplattenelemente ist es nun, dass jede Lichtleitermaterialschicht für die Strahlung, die in die Lichtleitermaterialschicht eingespeist und umgelenkt wird, optimiert werden kann, und zwar hinsichtlich sowohl des Materials als auch der für den homogenen seitlichen Strahlungsaustritt erforderlichen Strahlung und internen Ausgestaltung.

Das zuvor beschriebene Konzept kann auch invers eingesetzt werden, so dass die Lichtquellen Hinterleuchtungslicht in zumindest einen Teilbereich der unteren Seitenrandfläche einspeisen und das mindestens eine Näherungssensorik-Senderelement Sensorstrahlung in zumindest einen Teilbereich der oberen Seitenrandfläche einspeist.

In den beiden zuvor genannten Fällen können die beiden Lichtleitermaterialschichten getrennt hergestellt und als Plattenelemente aneinanderliegend angeordnet werden.

In weiterer zweckmäßiger Ausgestaltung der Erfindung kann die Anzeigevorrichtung versehen sein mit einem das Hinterleuchtungslicht und die Sensorstrahlung reflektierenden Reflektor an der der oberen Lichtleitermaterialschicht abgewandten Rückseite der unteren Lichtleitermaterialschicht und/oder einer das Hinterleuchtungslicht und die Sensorstrahlung reflektierenden Reflektionsbeschichtung an der der oberen Lichtleitermaterialschicht abgewandten Rückseite der unteren Lichtleitermaterialschicht.

Bei der zuvor beschriebenen Weiterbildung der Erfindung befindet sich ein für beide Strahlungen (Sensorstrahlung und Hinterleuchtungslicht) gemeinsamer Reflektor an der Rückseite der unteren Lichtleitermaterialschicht (d.h. des unteren Lichtleiterplattenelements). Eine Reflektionsschicht kann aber auch zusätzlich im Bereich zwischen den beiden Lichtleiterplattenelementen, d.h. zwischen der oberen und der unteren Lichtleitermaterialschicht angeordnet sein. Diese Reflektionsschicht ist dann allerdings selektiv reflektiv, reflektiert also die in das obere Lichtleiterplattenelement eingespeiste Strahlung, während er für aus dem unteren Lichtleiterplattenelement austretende Strahlung transmissiv ist. Insoweit ist der Reflektor zwischen den beiden Plattenelementen also halbdurchlässig. Derartige optische Filter, die in Abhängigkeit von der Wellenlänge entweder reflektiv oder transmissiv sind, sind grundsätzlich bekannt.

Das obige Konzept lässt sich nun umsetzen, indem die Anzeigevorrichtung beispielsweise versehen ist mit einem die Sensorstrahlung reflektierenden Reflektor an der der oberen Lichtleitermaterialschicht abgewandten Rückseite der unteren Lichtleitermaterialschicht oder einer die Sensorstrahlung reflektierende Reflektionsbeschichtung an der der oberen Lichtleitermaterialschicht abgewandten Rückseite der unteren Lichtleitermaterialschicht, wobei zwischen beiden Lichtleitermaterialschichten ein das Hinterleuchtungslicht reflektierender und für die Sensorstrahlung durchlässiger Reflektor angeordnet ist oder an einer der beiden einander zugewandten Seiten der beiden Lichtleitermaterialschichten eine das Hinterleuchtungslicht reflektierende und für die Sensorstrahlung durchlässige Beschichtung angeordnet ist.

Alternativ zu dem zuvor Gesagten kann die Anzeigevorrichtung auch versehen sein mit einem das Hinterleuchtungslicht reflektierenden Reflektor an der der oberen Lichtleitermaterialschicht abgewandten Rückseite der unteren Lichtleitermaterialschicht oder einer das Hinterleuchtungslicht reflektierende Reflektionsbeschichtung an der der oberen Lichtleitermaterialschicht abgewandten Rückseite der unteren Lichtleitermaterialschicht, wobei zwischen beiden Lichtleitermaterialschichten ein die Sensorstrahlung reflektierender und für das Hinterleuchtungslicht durchlässiger Reflektor angeordnet ist oder an einer der beiden einander zugewandten Seiten der beiden Lichtleitermaterialschichten eine die Sensorstrahlung reflektierende und für das Hinterleuchtungslicht durchlässige Beschichtung angeordnet ist.

Sofern im Vorstehenden von Reflektor die Rede ist, ist damit ein zusätzlich zur Lichtleiterplatte bzw. den Lichtleiterplattenelementen vorgesehenes Element gemeint, das beispielsweise ein Substrat mit einer entsprechenden Beschichtung aufweist, als auch eine Beschichtung gemeint, die auf die entsprechende Fläche der Lichtleiterplatte bzw. eines der Lichtleiterplattenelemente aufgetragen ist.

Gemäß einer weiteren Variante wird mit der Erfindung zur Lösung der obigen Aufgabe ferner eine Anzeigevorrichtung, insbesondere für ein Fahrzeug, vorgeschlagen, die versehen ist mit
- einem Display,
- einer Hinterleuchtungseinheit zum Hinterleuchten des Displays,
- wobei die Hinterleuchtungseinheit mehrere Lichtquellen für Hinterleuchtungslicht und eine Lichtleiterplatte mit einer dem Display zugewandten Lichtaustrittsseite, einer dieser gegenüberliegenden Rückseite und mit einer zwischen der Lichtaustrittsseite und der Rückseite angeordneten, umlaufenden Seitenrandfläche aufweist,
- wobei die Lichtquellen zwecks Einspeisung von Licht durch zumindest einen Teilbereich der Seitenrandfläche der Lichtleiterplatte in diese seitlich versetzt neben der Lichtleiterplatte angeordnet sind und seitlich in die Lichtleiterplatte eingespeistes Hinterleuchtungslicht aus der Lichtaustrittsseite der Lichtleiterplatte austritt,
- einer Näherungssensorik zum Sensieren eines sich im Bereich vor dem Display befindlichen Objekts wie z.B. eine Hand einer Person,
- wobei die Näherungssensorik mindestens ein Näherungssensorik-Senderelement zum Aussenden von nicht sichtbarer Sensorstrahlung, insbesondere IR-Sensorstrahlung, und mindestens ein Näherungssensorik-Empfangselement zum Empfangen von an einem Objekt im Bereich vor dem Display reflektierter Sensorstrahlung aufweist,
- wobei das mindestens eine Näherungssensor-Senderelement der Rückseite der Lichtleiterplatte zugewandt angeordnet ist und durch diese Sensorstrahlung in die Lichtleiterplatte einspeist und
- einem das Hinterleuchtungslicht reflektierenden und für die Sensorstrahlung durchlässigen Reflektor an der Rückseite der Lichtleiterplatte oder einer das Hinterleuchtungslicht reflektierenden und für die Sensorstrahlung durchlässigen Beschichtung an der Rückseite der Lichtleiterplatte,
- wobei das mindestens eine Näherungssensorik-Empfangselement innerhalb des Displays und/oder zwischen dem Display und der Lichtleiterplatte und/oder hinter der Lichtleiterplatte angeordnet ist.

Bei dieser Variante der Erfindung befinden sich der oder die Näherungssensorik-Senderelemente hinter der Lichtleiterplatte und sind damit deren Rückseite zugewandt, über die sie die Sensorstrahlung in die Lichtleiterplatte einspeisen.

Auch bei dieser Variante kann zweckmäßigerweise vorgesehen sein, dass die Lichtleiterplatte eine obere Lichtleitermaterialschicht mit einer umlaufenden oberen Seitenrandfläche und eine untere Lichtleitermaterialschicht mit einer umlaufenden unteren Seitenrandfläche umfasst, wobei die Lichtquellen Hinterleuchtungslicht in zumindest einen Teilbereich der einen, z.B. der oberen Seitenrandfläche einspeisen und das mindestens eine Näherungssensorik-Senderelement Sensorstrahlung in zumindest einen Teilbereich der der oberen Lichtleitermaterialschicht abgewandten Rückseite der unteren Lichtleitermaterialschicht einspeist, und dass zwischen beiden Lichtleitermaterialschichten ein das Hinterleuchtungslicht reflektierender und für die Sensorstrahlung durchlässiger Reflektor angeordnet ist oder an einer der beiden einander zugewandten Seiten der beiden Lichtleitermaterialschichten eine das Hinterleuchtungslicht reflektierende und die Sensorstrahlung durchlässige Beschichtung angeordnet ist.

Wie bereits oben erwähnt, hat die Lichtleiterplatte die Eigenschaft, eingespeiste Strahlung zu reflektieren und zu streuen, um sie möglichst homogen aus der Lichtaustrittsseite austreten zu lassen. Die hierfür erforderlichen Maßnahmen für die Reflektion und Streuung sind grundsätzlich bekannt und umfassen auf zumindest einer der beiden Hauptflächen der Lichtleiterplatte ausgebildete Oberflächenstrukturen und/oder lichtstreuende Partikel oder Strukturen innerhalb der Lichtleiterplatte.

Zusätzlich kann auch noch zwischen der Lichtaustrittsseite der Lichtleiterplatte und dem Display zur weiteren Homogenisierung des Hinterleuchtungslicht und gegebenenfalls der Sensorstrahlung ein optischer Diffusor angeordnet sein.

Die Erfindung wird nachfolgend anhand mehrerer Ausführungsbeispiele und unter Bezugnahme auf die Zeichnung näher erläutert. Im Einzelnen zeigen dabei:
- Fig. 1: schematisch die für die Erfindung wesentlichen Merkmale des Aufbaus einer Anzeigevorrichtung gemäß einem ersten Ausführungsbeispiel,
- Fig. 2: schematisch die für die Erfindung wesentlichen Merkmale des Aufbaus einer Anzeigevorrichtung gemäß einem zweiten Ausführungsbeispiel,
- Fig. 3: schematisch die für die Erfindung wesentlichen Merkmale des Aufbaus einer Anzeigevorrichtung gemäß einem dritten Ausführungsbeispiel,
- Fig. 4: schematisch die für die Erfindung wesentlichen Merkmale des Aufbaus einer Anzeigevorrichtung gemäß einem vierten Ausführungsbeispiel,
- Fig. 5: schematisch die für die Erfindung wesentlichen Merkmale des Aufbaus einer Anzeigevorrichtung gemäß einem fünften Ausführungsbeispiel,
- Fig. 6: schematisch die für die Erfindung wesentlichen Merkmale des Aufbaus einer Anzeigevorrichtung gemäß einem sechsten Ausführungsbeispiel und
- Fig. 7: schematisch die für die Erfindung wesentlichen Merkmale des Aufbaus einer Anzeigevorrichtung gemäß einem siebten Ausführungsbeispiel.

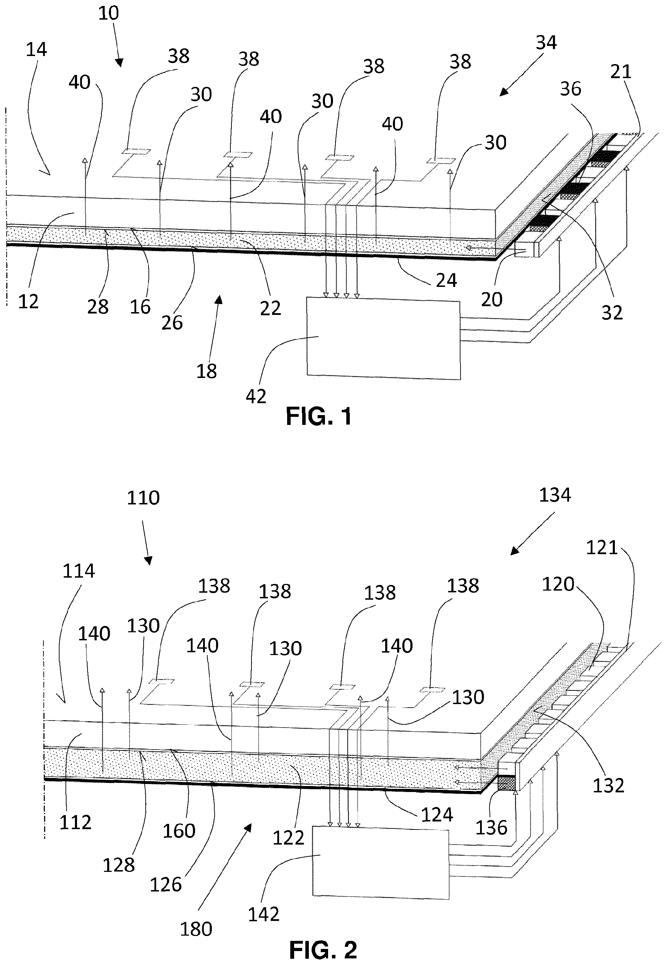

In Fig. 1 ist ein erstes Ausführungsbeispiel einer Anzeigevorrichtung 10 schematisch hinsichtlich der für die Erfindung wesentlichen Elemente gezeigt. Die Anzeigevorrichtung 10 weist ein Display 12 auf, das beispielsweise in LCD-Technologie ausgeführt ist. Andere Konstruktionen zur optischen Darstellung von Zeichen, Grafiken o.dgl. sind ebenfalls möglich.

Das Display 12 hat eine Anzeigeseite 14 sowie eine dieser abgewandte Rückseite 16. Unterhalb des Displays 12 befindet sich eine Hinterleuchtungseinheit 18, die als Edge-Light-Konzept ausgeführte Lichtquellen 20 in beispielsweise der Form von LEDs, die auf einem Trägerstreifen 21 (z.B. starren oder flexiblen Leiterplatine) angeordnet sind, und eine Lichtleiterplatte 22 sowie einen unterhalb der Lichtleiterplatte 22 befindlichen Reflektor 24 aufweist. Anstelle des Reflektors 24 kann die dem Display 12 abgewandte Rückseite 26 der Lichtleiterplatte 22 auch mit einer reflektiven Beschichtung versehen sein.

Aus der dem Display 12 zugewandten Lichtaustrittsseite 28 der Lichtleiterplatte 22 tritt dasjenige Hinterleuchtungslicht (angedeutet durch die Pfeile 30) aus, das von den Lichtquellen 20 in die Seitenrandfläche 32 der Lichtleiterplatte 22 eingespeist wird.

Die Anzeigevorrichtung 10 umfasst ferner eine optisch arbeitende Näherungssensorik 34, die einerseits ein oder mehrere Näherungssensorik-Senderelemente 36 sowie ein oder mehrere Näherungssensorik-Empfangselemente 38 aufweist. Diese Näherungssensorik-Empfangselemente sind entweder im Display 12 integriert oder aber auch hinter dem Display 12 angeordnet. Die Näherungssensorik-Senderelemente 36 senden Sensorstrahlung im nicht sichtbaren Wellenlängenbereich (beispielsweise in Form von IR-Strahlung) aus, die wie das Hinterleuchtungslicht über die Seitenrandfläche 32 in die Lichtleiterplatte 22 eingespeist und dort, ebenfalls wie das Hinterleuchtungslicht 30, durch Reflektion und Umlenkung aus der Lichtaustrittsseite 28 austritt, um als Sensorlicht (siehe die Pfeile 40) in den Bereich bzw. Raum vor der Lichtaustrittsseite 28 des Displays 12 zu gelangen. Ein in diesem Bereich bzw. Raum angeordnetes Objekt, wie beispielsweise eine Hand oder ein Finger einer Hand einer Person, wird erkannt, indem die Sensorstrahlung 40 reflektiert wird und von einem oder mehreren Näherungssensorik-Empfangselementen 38 empfangen wird. Die Auswertung der von den Näherungssensorik-Empfangselementen 38 gelieferten Signale erfolgt in einer Auswerteeinheit 42, die überdies die Näherungssensorik-Senderelemente 36 ansteuert. Durch entsprechende sequentielle Ansteuerung der Näherungssensorik-Senderelemente 36 und durch Kenntnis des Ortes, d.h. der Platzierung derjenigen Näherungssensorik-Empfangselemente 38, die die sequentiell ausgesendete Sensorstrahlung empfängt bzw. empfangen, kann ein Objekt oberhalb des Displays 12 bzw. vor dem Display 12 geortet bzw. hinsichtlich seiner Position in etwa erfasst werden. Dabei lässt sich beispielsweise eine Gestenerkennung realisieren.

Bei dem ersten Ausführungsbeispiel der Anzeigevorrichtung befinden sich also die Lichtquellen 20 und die vorzugsweise als LEDs ausgeführten Näherungssensorik-Senderelemente 36 seitlich der Lichtleiterplatte 22 und vorzugsweise längs mehrerer Seitenränder der Lichtleiterplatte 22. Damit bedarf es also nicht der Anordnung von Näherungssensorik-Senderelementen bzw. Lichtquellen unterhalb der Lichtleiterplatte 22, so dass die Bautiefe der Anzeigevorrichtung 10 verringert ist.

In Fig. 2 ist ein zweites Ausführungsbeispiel einer Anzeigevorrichtung 110 gezeigt. Soweit die dort gezeigten Elemente denjenigen der Anzeigevorrichtung 10 der Fig. 1 konstruktiv bzw. funktional entsprechen, sind sie mit um 100 erhöhte Bezugsziffern kenntlich gemacht.

Im Unterschied zur Anzeigevorrichtung 10 sind bei der Anzeigevorrichtung 110 der Fig. 2 die Lichtquellen 120 und die Näherungssensorik-Senderelemente 136 in zwei übereinander angeordneten Reihen auf einem Trägerstreifen 21angeordnet. Die Lichtleiterplatte 122 ist entsprechend in ihrer Höhe vergrößert, so dass wiederum beide Strahlung aussendenden Elemente, nämlich die Lichtquellen 120 und die Näherungssensorik-Senderelemente 136 wiederum seitlich über eine der Seitenrandflächen 132 bzw. auch mehrere der Seitenrandflächen 132 Strahlung in die Lichtleiterplatte 122 einbringen. Der weitere Aufbau der Anzeigevorrichtung 110 ist im Wesentlichen gleich demjenigen der Anzeigevorrichtung 10.

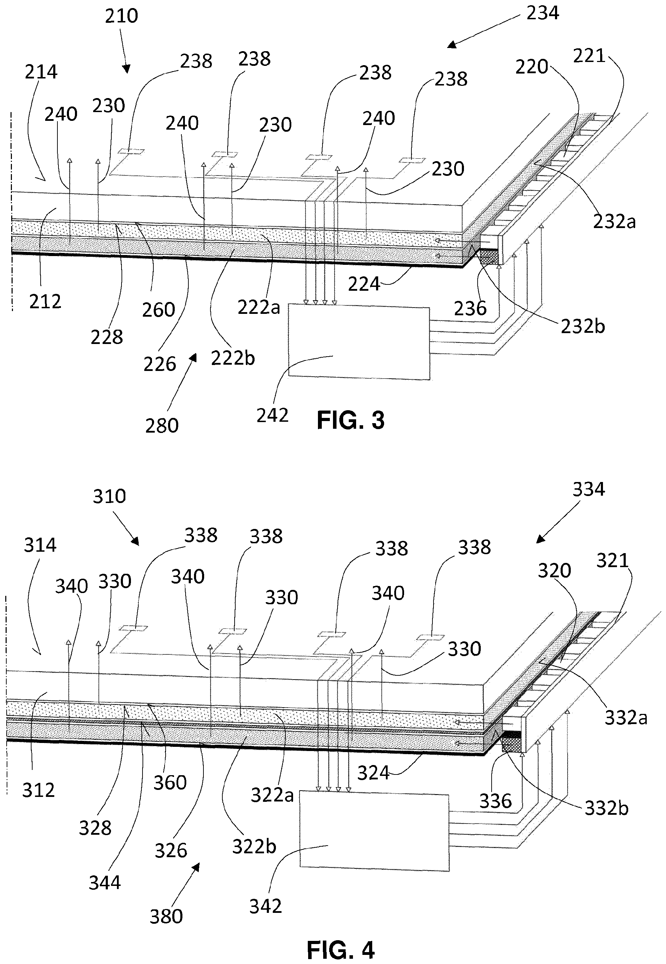

In Fig. 3 ist schematisch der prinzipielle Aufbau eines dritten Ausführungsbeispiels einer Anzeigevorrichtung 210 gezeigt. In Fig. 3 sind diejenigen Elemente, die funktionsgleich bzw. identisch zu den Anzeigevorrichtungselementen der Fig. 1 sind, mit um 200 erhöhten Bezugszeichen gekennzeichnet.

Wie im Ausführungsbeispiel der Anzeigevorrichtung 110 der Fig. 2 sind auch bei der Anzeigevorrichtung 210 der Fig. 3 die Strahlung aussendenden Elemente, nämlich die Lichtquellen 220 und die Näherungssensorik-Senderelemente 236 in zwei übereinander angeordneten Reihen auf dem Trägerstreifen 221 angeordnet. Im Unterschied zu den Anzeigevorrichtungen 10 und 110 ist die Lichtleiterplatte 222 in Form zweier übereinander angeordneter Lichtleiterplattenelemente 222a und 222b ausgebildet. Jedes dieser Lichtleiterplattenelemente 222a, 222b empfängt Strahlung entweder von den Lichtquellen 220 bzw. den Näherungssensorik-Senderelementen 236. In die Seitenrandfläche 232a des in Fig. 3 oberen Lichtleiterplattenelements 222a gelangt die Strahlung der Lichtquellen 220, d.h. das Hinterleuchtungslicht, während in die Seitenrandfläche 232b des unteren Lichtleiterplattenelements 222b die IR-Sensorstrahlung der Näherungssensorik-Senderelemente 236 gelangt. Unterhalb der zweiteiligen Lichtleiterplatte 222 befindet sich wiederum ein Reflektor 224 bzw. ist die Unterseite des unteren Lichtleiterplattenelements 222b mit einer Reflektionseigenschaften aufweisenden Beschichtung versehen. Durch die Aufteilung der Lichtleiterplatte 222 in die beiden Lichtleiterplattenelemente 222a und 222b ist es möglich, durch Wahl der Lichtleitermaterialien und dessen Ausführung dafür zu sorgen, dass die optischen Eigenschaften an die jeweilige Strahlung (Hinterleuchtungslicht bzw. Sensorstrahlung) angepasst und damit optimiert werden kann.

Fig. 4 zeigt ein Ausführungsbeispiel einer Anzeigevorrichtung 310, bei der wiederum gilt, dass diejenigen Elemente, die den Elementen der Anzeigevorrichtung 210 gleichen bzw. identisch zu diesen sind, mit um 100 erhöhte Bezugszeichen gekennzeichnet sind.

Der Unterscheid der Anzeigevorrichtung 310 gegenüber derjenigen nach Fig. 3 ist in der zusätzlichen Anordnung eines halbdurchlässigen Reflektors 344 bzw. einer halbdurchlässigen Beschichtung zu sehen, die zwischen den beiden Lichtleiterplattenelementen 322a und 322b angeordnet ist. Dieser semitransparente Reflektor 344 bzw. diese semitransparente Beschichtung, die entweder an der Unterseite des oberen Lichtleiterplattenelements 322a oder an der Oberseite des unteren Lichtleiterplattenelements 322b angeordnet ist, reflektiert nur das in das obere Lichtleiterplattenelement 322a eingespeiste Hinterleuchtungslicht, während er die Sensorstrahlung, die aus dem unteren Lichtleiterplattenelement 322b austritt, hindurchlässt.

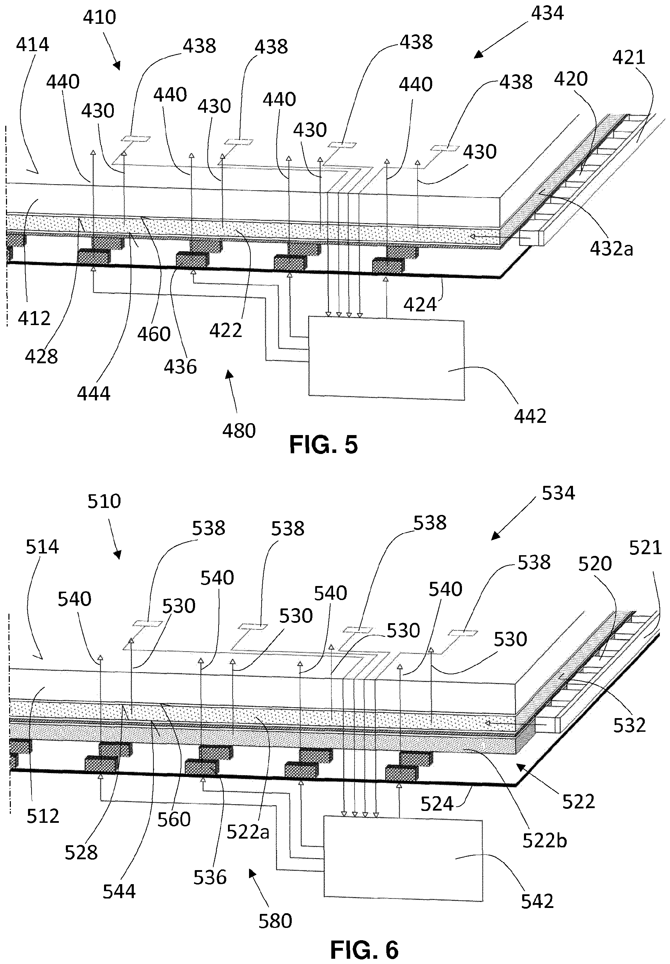

In den Fign. 5 und 6 sind zwei Ausführungsbeispiele von Anzeigevorrichtungen 410 bzw. 510 gezeigt, bei denen anders als in den Ausführungsbeispielen der Fign. 1 bis 4 die Näherungssensorik-Senderelemente unterhalb der Lichtleiterplatte angeordnet sind. Auch hier gilt, dass diejenigen Komponenten der Anzeigevorrichtung 410, die funktions- bzw. konstruktionsgleich zu denjenigen der Anzeigevorrichtung 10 der Fig. 1 sind, durch 400 erhöhte Bezugszeichen kenntlich gemacht sind.

An der Unterseite der Lichtleiterplatte 422 befindet sich ein halbdurchlässiger Reflektor 444 bzw. eine halbdurchlässige Reflektionsbeschichtung, der bzw. die einerseits das Hinterleuchtungslicht (siehe die Pfeile 430) der Lichtquellen 420 reflektiert, und zwar in Richtung Lichtaustrittsseite der Lichtleiterplatte 422, und andererseits die von unten kommende Sensorstrahlung (siehe die Pfeile 440) hindurchlässt.

Die Anzeigevorrichtung 510 der Fig. 6 weist zusätzlich zu der Anzeigevorrichtung 410 der Fig. 5 unterhalb des halbdurchlässigen Reflektors 544 noch ein Lichtleiterplattenelement 522b auf, das zusammen mit dem für die Verteilung des Hinterleuchtungslichts verantwortlichen Lichtleiterplattenelement 522a die Lichtleiterplatte 522 bildet.

Es sei an dieser Stelle noch angemerkt, dass die Anordnung der Lichtquellen und der Näherungssensorik-Senderelemente gegenüber der Situation in den Fign. 5 und 6 vertauscht werden kann. Die Hinterleuchtungslichtquellen können also unterhalb der Lichtleiterplatte bzw. der Anordnung der beiden Lichtplattenelemente angeordnet sein, während sich dann die Näherungssensorik-Senderelemente seitlich der Lichtleiterplatte bzw. seitlich einer der Lichtleiterplattenelemente befinden.

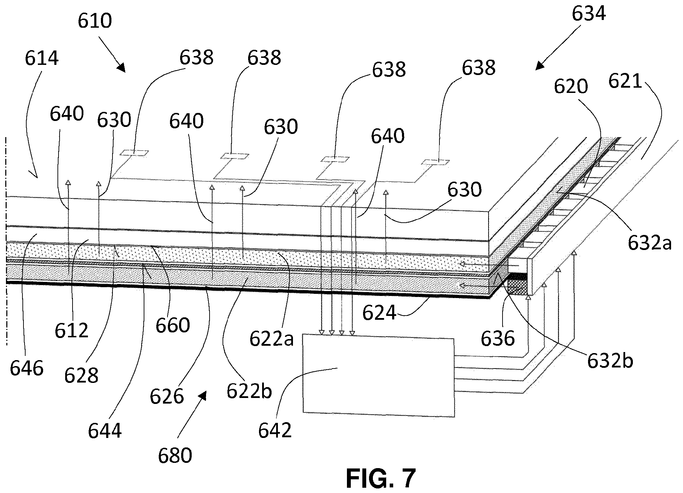

Wie bereits oben beschrieben, gilt für sämtliche hier beschriebenen Ausführungsbeispiele der Anzeigevorrichtungen 10, 110, 210, 310, 410 und 510, dass die Lichtleiterplatten bzw. Lichtleiterplattenelemente für eine Homogenisierung der aus ihnen austretenden Strahlung sorgen. Dies erfolgt durch im Stand der Technik grundsätzlich bekannte Maßnahmen zur Streuung und/oder Reflektion auf Grund interner Reflektionen innerhalb der Lichtleiterplatten. Zur weiteren Homogenisierung der austretenden Strahlung kann zwischen den Lichtleiterplatten und dem Display auch ein Diffusor angeordnet sein, wie es beispielhaft in Fig. 7 anhand der Anzeigevorrichtung 610 gezeigt ist (siehe den Diffusor 646).

Ferner ist jedes Display bzw. bei jedem Ausführungsbeispiel der Anzeigevorrichtung zweckmäßigerweise noch eine Touchsensorik integriert, die der Übersichtlichkeit halber in den Figuren nicht gezeigt ist.

### BEZUGSZEICHENLISTE

- 10: Anzeigevorrichtung
- 12: Display
- 14: Anzeigeseite des Displays
- 16: Rückseite des Displays
- 18: Hinterleuchtungseinheit
- 20: Lichtquellen
- 21: Trägerstreifen
- 22: Lichtleiterplatte
- 24: Reflektor
- 26: Rückseite der Lichtleiterplatte
- 28: Lichtaustrittsseite der Lichtleiterplatte
- 30: Hinterleuchtungslicht
- 32: Seitenrandfläche der Lichtleiterplatte
- 34: Näherungssensorik
- 36: Näherungssensorik-Senderelemente
- 38: Näherungssensorik-Empfangselemente
- 40: Sensorstrahlung
- 42: Auswerteeinheit
- 110: Anzeigevorrichtung
- 112: Display
- 114: Anzeigeseite des Displays
- 116: Rückseite des Displays
- 118: Hinterleuchtungseinheit
- 120: Lichtquellen
- 121: Trägerstreifen
- 122: Lichtleiterplatte
- 124: Reflektor
- 126: Rückseite der Lichtleiterplatte
- 128: Lichtaustrittsseite der Lichtleiterplatte
- 130: Hinterleuchtungslicht
- 132: Seitenrandfläche der Lichtleiterplatte
- 134: Näherungssensorik
- 136: Näherungssensorik-Senderelemente
- 138: Näherungssensorik-Empfangselemente
- 140: Sensorstrahlung
- 142: Auswerteeinheit
- 210: Anzeigevorrichtung
- 212: Display
- 214: Anzeigeseite des Displays
- 216: Rückseite des Displays
- 218: Hinterleuchtungseinheit
- 220: Lichtquellen
- 221: Trägerstreifen
- 222a: obere Lichtleiterplattenelemente
- 222b: untere Lichtleiterplattenelemente
- 224: Reflektor
- 226: Rückseite der Lichtleiterplatte
- 228: Lichtaustrittsseite der Lichtleiterplatte
- 230: Hinterleuchtungslicht
- 232a: Seitenrandfläche der oberen Lichtleiterplattenelemente
- 232b: Seitenrandfläche der unteren Lichtleiterplattenelemente
- 234: Näherungssensorik
- 236: Näherungssensorik-Senderelemente
- 238: Näherungssensorik-Empfangselemente
- 240: Sensorstrahlung
- 242: Auswerteeinheit
- 310: Anzeigevorrichtung
- 312: Display
- 314: Anzeigeseite des Displays
- 316: Rückseite des Displays
- 318: Hinterleuchtungseinheit
- 320: Lichtquellen
- 321: Trägerstreifen
- 322a: obere Lichtleiterplattenelement
- 322b: untere Lichtleiterplattenelemente
- 324: Reflektor
- 326: Rückseite der Lichtleiterplatte
- 328: Lichtaustrittsseite der Lichtleiterplatte
- 330: Hinterleuchtungslicht
- 332a: Seitenrandfläche der oberen Lichtleiterplattenelemente
- 332b: Seitenrandfläche der unteren Lichtleiterplattenelemente
- 334: Näherungssensorik
- 336: Näherungssensorik-Senderelemente
- 338: Näherungssensorik-Empfangselemente
- 340: Sensorstrahlung
- 342: Auswerteeinheit
- 344: Reflektor
- 410: Anzeigevorrichtung
- 412: Display
- 414: Anzeigeseite des Displays
- 416: Rückseite des Displays
- 418: Hinterleuchtungseinheit
- 420: Lichtquellen
- 421: Trägerstreifen
- 422: Lichtleiterplatte
- 424: Reflektor
- 426: Rückseite der Lichtleiterplatte
- 428: Lichtaustrittsseite der Lichtleiterplatte
- 430: Hinterleuchtungslicht
- 432: Seitenrandfläche der Lichtleiterplatte
- 434: Näherungssensorik
- 436: Näherungssensorik-Senderelemente
- 438: Näherungssensorik-Empfangselemente
- 440: Sensorstrahlung
- 442: Auswerteeinheit
- 444: Reflektor
- 510: Anzeigevorrichtung
- 512: Display
- 514: Anzeigeseite des Displays
- 516: Rückseite des Displays
- 518: Hinterleuchtungseinheit
- 520: Lichtquellen
- 521: Trägerstreifen
- 522a: obere Lichtleiterplatte
- 522b: untere Lichtleiterplatte
- 524: Reflektor
- 526: Rückseite der Lichtleiterplatte
- 528: Lichtaustrittsseite der Lichtleiterplatte
- 530: Hinterleuchtungslicht
- 532: Seitenrandfläche der Lichtleiterplatte
- 534: Näherungssensorik
- 536: Näherungssensorik-Senderelemente
- 538: Näherungssensorik-Empfangselemente
- 540: Sensorstrahlung
- 542: Auswerteeinheit
- 544: Reflektor
- 610: Anzeigevorrichtung
- 612: Display
- 614: Anzeigeseite des Displays
- 616: Rückseite des Displays
- 618: Hinterleuchtungseinheit
- 620: Lichtquellen
- 621: Trägerstreifen
- 622a: obere Lichtleiterplatte
- 622b: untere Lichtleiterplatte
- 624: Reflektor
- 626: Rückseite der Lichtleiterplatte
- 628: Lichtaustrittsseite der Lichtleiterplatte
- 630: Hinterleuchtungslicht
- 632a: Seitenrandfläche der oberen Lichtleiterplattenelemente
- 632b: Seitenrandfläche der unteren Lichtleiterplattenelemente
- 634: Näherungssensorik
- 636: Näherungssensorik-Senderelemente
- 638: Näherungssensorik-Empfangselemente
- 640: Sensorstrahlung
- 642: Auswerteeinheit
- 644: Reflektor
- 646: Diffusor

## Patentansprüche

1. Anzeigevorrichtung, insbesondere für ein Fahrzeug, mit
- einem Display (12),
- einer Hinterleuchtungseinheit (18) zum Hinterleuchten des Displays (12),
- wobei die Hinterleuchtungseinheit (18) mehrere Lichtquellen (20) für Hinterleuchtungslicht (30) und eine Lichtleiterplatte (22) mit einer dem Display (12) zugewandten Lichtaustrittsseite (28), einer dieser gegenüberliegenden Rückseite (26) und mit einer zwischen der Lichtaustrittsseite (28) und der Rückseite (26) angeordneten, umlaufenden Seitenrandfläche (32) aufweist,
- wobei die Lichtquellen (20) zwecks Einspeisung von Licht durch zumindest einen Teilbereich der Seitenrandfläche (32) der Lichtleiterplatte (22) in diese seitlich versetzt neben der Lichtleiterplatte (22) angeordnet sind und seitlich in die Lichtleiterplatte (22) eingespeistes Hinterleuchtungslicht (30) aus der Lichtaustrittsseite (28) der Lichtleiterplatte (22) austritt und
- einer Näherungssensorik (34) zum Sensieren eines sich im Bereich vor dem Display (12) befindlichen Objekts wie z.B. eine Hand einer Person,
- wobei die Näherungssensorik (34) mindestens ein Näherungssensorik-Senderelement (36) zum Aussenden von nicht sichtbarer Sensorstrahlung, insbesondere IR-Sensorstrahlung, und mindestens ein Näherungssensorik-Empfangselement (38) zum Empfangen von an einem Objekt im Bereich vor dem Display (12) reflektierter Sensorstrahlung aufweist und
- wobei das mindestens eine Näherungssensorik-Senderelement (36) seitlich versetzt zu einem Bereich der Seitenrandfläche (32) der Lichtleiterplatte (22) angeordnet ist und die Sensorstrahlung in diesem Bereich in die Seitenrandfläche (32) der Lichtleiterplatte (22) eingespeist sowie aus der Lichtaustrittsseite (28) der Lichtleiterplatte (22) austritt,
**dadurch gekennzeichnet ,**
- **dass** das mindestens eine Näherungssensorik-Empfangselement (38) zwischen dem Display (12) und der Lichtleiterplatte (22) und/oder der Rückseite (26) der Lichtleiterplatte (22) gegenüberliegend angeordnet ist.

2. Anzeigevorrichtung nach Anspruch 1, **dadurch gekennzeichnet, dass** das mindestens eine Näherungssensorik-Senderelement (36) zwischen den Lichtquellen (20) der Hinterleuchtungseinheit (18) angeordnet ist.

3. Anzeigevorrichtung nach Anspruch 1 oder 2, **dadurch gekennzeichnet, dass** an der Rückseite (26) der Lichtleiterplatte (22) ein das Hinterleuchtungslicht (30) und die Sensorstrahlung reflektierender Reflektor (24) angeordnet ist oder dass die Rückseite (26) der Lichtleiterplatte (22) eine das Hinterleuchtungslicht (30) oder die Sensorstrahlung reflektierende Reflektionsbeschichtung aufweist.

4. Anzeigevorrichtung nach Anspruch 1, **dadurch gekennzeichnet, dass** das mindestens eine Näherungssensorik-Senderelement (136; 236; 336) unter- und/oder oberhalb der Ebene positioniert ist, in der die Lichtquellen (120; 220; 320) angeordnet sind.

5. Anzeigevorrichtung nach Anspruch 4, **dadurch gekennzeichnet, dass** die Lichtleiterplatte (122; 222; 322) eine obere Lichtleitermaterialschicht mit einer umlaufenden oberen Seitenrandfläche und eine untere Lichtleitermaterialschicht mit einer umlaufenden unteren Seitenrandfläche umfasst, wobei die Lichtquellen (122; 222; 322) Hinterleuchtungslicht (130; 230; 330) in zumindest einen Teilbereich der oberen Seitenrandfläche einspeisen und das mindestens eine Näherungssensorik-Senderelement (136; 236; 336) Sensorstrahlung in zumindest einen Teilbereich der unteren Seitenrandfläche einspeist, wobei jedes Lichtleiterplattenelement der Umlenkung unterschiedlicher Strahlung dient.

6. Anzeigevorrichtung nach Anspruch 4, **dadurch gekennzeichnet, dass** die Lichtleiterplatte (122; 222; 322) eine obere Lichtleitermaterialschicht mit einer umlaufenden oberen Seitenrandfläche und eine untere Lichtleitermaterialschicht mit einer umlaufenden unteren Seitenrandfläche umfasst, wobei die Lichtquellen (120; 220; 320) Hinterleuchtungslicht (130; 230; 330) in zumindest einen Teilbereich der unteren Seitenrandfläche einspeisen und das mindestens eine Näherungssensorik-Senderelement (136; 236; 336) Sensorstrahlung in zumindest einen Teilbereich der oberen Seitenrandfläche einspeist.

7. Anzeigevorrichtung nach Anspruch 5 oder 6, **dadurch gekennzeichnet, dass** die beiden Lichtleitermaterialschichten aneinanderliegen.

8. Anzeigevorrichtung nach einem der Ansprüche 5 bis 7, **gekennzeichnet durch** einen das Hinterleuchtungslicht (130; 230; 330) und die Sensorstrahlung reflektierenden Reflektor an der der oberen Lichtleitermaterialschicht abgewandten Rückseite der unteren Lichtleitermaterialschicht und/oder eine das Hinterleuchtungslicht (130; 230; 330) und die Sensorstrahlung reflektierenden Reflektionsbeschichtung an der der oberen Lichtleitermaterialschicht abgewandten Rückseite der unteren Lichtleitermaterialschicht.

9. Anzeigevorrichtung nach Anspruch 5 oder den Ansprüchen 5 und 7, **gekennzeichnet durch** einen die Sensorstrahlung reflektierenden Reflektor an der der oberen Lichtleitermaterialschicht abgewandten Rückseite der unteren Lichtleitermaterialschicht oder eine die Sensorstrahlung reflektierende Reflektionsbeschichtung an der der oberen Lichtleitermaterialschicht abgewandten Rückseite der unteren Lichtleitermaterialschicht, wobei zwischen beiden Lichtleitermaterialschichten ein das Hinterleuchtungslicht (30; 130; 230) reflektierender und für die Sensorstrahlung durchlässiger Reflektor angeordnet ist oder an einer der beiden einander zugewandten Seiten der beiden Lichtleitermaterialschichten eine das Hinterleuchtungslicht reflektierende und für die Sensorstrahlung durchlässige Beschichtung angeordnet ist.

10. Anzeigevorrichtung nach Anspruch 6 oder 7, **gekennzeichnet durch** einen das Hinterleuchtungslicht (130; 230; 330) reflektierenden Reflektor an der der oberen Lichtleitermaterialschicht abgewandten Rückseite der unteren Lichtleitermaterialschicht oder eine das Hinterleuchtungslicht (130; 230; 330) reflektierende Reflektionsbeschichtung an der der oberen Lichtleitermaterialschicht abgewandten Rückseite der unteren Lichtleitermaterialschicht, wobei zwischen beiden Lichtleitermaterialschichten ein die Sensorstrahlung reflektierender und für das Hinterleuchtungslicht (130; 230; 330) durchlässiger Reflektor angeordnet ist oder an einer der beiden einander zugewandten Seiten der beiden Lichtleitermaterialschichten eine die Sensorstrahlung reflektierende und für das Hinterleuchtungslicht (130; 230; 330) durchlässige Beschichtung angeordnet ist.

11. Anzeigevorrichtung, insbesondere für ein Fahrzeug, mit
- einem Display (412),
- einer Hinterleuchtungseinheit (418) zum Hinterleuchten des Displays (412),
- wobei die Hinterleuchtungseinheit (418) mehrere Lichtquellen für Hinterleuchtungslicht (430) und eine Lichtleiterplatte (422) mit einer dem Display (412) zugewandten Lichtaustrittsseite (428), einer dieser gegenüberliegenden Rückseite (426) und mit einer zwischen der Lichtaustrittsseite (428) und der Rückseite (426) angeordneten, umlaufenden Seitenrandfläche (432) aufweist,
- wobei die Lichtquellen (420) zwecks Einspeisung von Licht durch zumindest einen Teilbereich der Seitenrandfläche (432) der Lichtleiterplatte (422) in diese seitlich versetzt neben der Lichtleiterplatte (422) angeordnet sind und seitlich in die Lichtleiterplatte eingespeistes Hinterleuchtungslicht (430) aus der Lichtaustrittsseite (428) der Lichtleiterplatte (422) austritt,
- einer Näherungssensorik zum Sensieren eines sich im Bereich vor dem Display (412) befindlichen Objekts wie z.B. eine Hand einer Person,
- wobei die Näherungssensorik mindestens ein Näherungssensorik-Senderelement (436) zum Aussenden von nicht sichtbarer Sensorstrahlung, insbesondere IR-Sensorstrahlung, und mindestens ein Näherungssensorik-Empfangselement (438) zum Empfangen von an einem Objekt im Bereich vor dem Display (412) reflektierter Sensorstrahlung aufweist,
- wobei das mindestens eine Näherungssensor-Senderelement (436) der Rückseite (426) der Lichtleiterplatte (422) zugewandt angeordnet ist und durch diese Sensorstrahlung in die Lichtleiterplatte (422) einspeist und
- einem das Hinterleuchtungslicht (430) reflektierenden und für die Sensorstrahlung durchlässigen Reflektor (424) an der Rückseite (426) der Lichtleiterplatte (422) oder einer das Hinterleuchtungslicht (430) reflektierenden und für die Sensorstrahlung durchlässigen Beschichtung an der Rückseite der Lichtleiterplatte (422),
**dadurch gekennzeichnet ,**
- **dass** das mindestens eine Näherungssensorik-Empfangselement (438) zwischen dem Display (412) und der Lichtleiterplatte (422) und/oder der Rückseite (26) der Lichtleiterplatte (422) gegenüberliegend angeordnet ist.

12. Anzeigevorrichtung nach Anspruch 11, **dadurch gekennzeichnet, dass** die Lichtleiterplatte (522) eine obere Lichtleitermaterialschicht mit einer umlaufenden oberen Seitenrandfläche und eine untere Lichtleitermaterialschicht mit einer umlaufenden unteren Seitenrandfläche umfasst, wobei die Lichtquellen (520) Hinterleuchtungslicht (530) in zumindest einen Teilbereich der einen, z.B. der oberen Seitenrandfläche einspeisen und das mindestens eine Näherungssensorik-Senderelement (536) Sensorstrahlung in zumindest einen Teilbereich der der oberen Lichtleitermaterialschicht abgewandten Rückseite der unteren Lichtleitermaterialschicht einspeist, und dass zwischen beiden Lichtleitermaterialschichten ein das Hinterleuchtungslicht (530) reflektierender und für die Sensorstrahlung durchlässiger Reflektor angeordnet ist oder an einer der beiden einander zugewandten Seiten der beiden Lichtleitermaterialschichten eine das Hinterleuchtungslicht (530) reflektierende und die Sensorstrahlung durchlässige Beschichtung angeordnet ist.

13. Anzeigevorrichtung nach einem der Ansprüche 1 bis 12, **dadurch gekennzeichnet, dass** die Lichtleiterplatte (22; 122; 222; 322; 422; 522) zumindest für das Hinterleuchtungslicht (30; 130; 230; 330; 430; 530) und vorzugsweise auch für die Sensorstrahlung optisch diffus ausgebildet ist.

14. Anzeigevorrichtung nach einem der Ansprüche 1 bis 13, **gekennzeichnet durch** einen optischen Diffusor zwischen der Lichtaustrittsseite der Lichtleiterplatte (22; 122; 222; 322; 422; 522) und dem Display (12; 112; 212; 312; 412; 512) zur weiteren Homogenesierung des Hinterleuchtungslichts (30; 130; 230; 330; 430; 530) und gegebenenfalls der Sensorstrahlung.

15. Anzeigevorrichtung nach einem der Ansprüche 1 bis 14, **dadurch gekennzeichnet, dass** das Display mit einer Touchsensorik versehen ist.

## Claims

1. A display device, in particular for a vehicle, comprising
- a display (12),
- a backlighting unit (18) for backlighting the display (12),
- wherein the backlighting unit (18) comprises a plurality of light sources (20) for backlight (30) and a light guide plate (22) having a light emission side (28) facing the display (12), an opposite rear side (26) and a circumferential side edge surface (32) arranged between the light emission side (28) and the rear side (26),
- wherein the light sources (20) are arranged next to the light guide plate (22) in a laterally offset manner for feeding light through at least a partial area of the side edge surface (32) of the light guide plate (22) into the latter, and wherein backlight (30) fed into the light guide plate (22) from the side is emitted from the light emission side (28) of the light guide plate (22), and
- a proximity sensor system (34) for sensing an object located in the area in front of the display (12), for example a hand of a person,
- wherein the proximity sensor system (34) comprises at least one proximity sensor system transmitter element (36) for transmitting invisible sensor radiation, in particular IR sensor radiation, and at least one proximity sensor system receiver element (38) for receiving sensor radiation reflected from an object in the area in front of the display (12), and
- wherein the at least one proximity sensor system transmitter element (36) is arranged laterally offset from an area of the side edge surface (32) of the light guide plate (22) and wherein the sensor radiation in this area is fed into the side edge surface (32) of the light guide plate (22) and is emitted from the light emission side (28) of the light guide plate (22), **characterized in that**
- the at least one proximity sensor system receiver element (38) is arranged between the display (12) and the light guide plate (22) and/or opposite to the rear side (26) of the light guide plate (22).

2. The display device according to claim 1, **characterized in that** the at least one proximity sensor system transmitter element (36) is arranged between the light sources (20) of the backlighting unit (18).

3. The display device according to claim 1 or 2, **characterized in that** on the rear side (26) of the light guide plate (22) a reflector (24) reflecting the backlight (30) and the sensor radiation is arranged, or that the rear side (26) of the light guide plate (22) comprises a reflective coating reflecting the backlight (30) or the sensor radiation.

4. The display device according to claim 1, **characterized in that** the at least one proximity sensor system transmitter element (136; 236; 336) is positioned below and/or above the plane in which the light sources (120; 220; 320) are arranged.

5. The display device according to claim 4, **characterized in that** the light guide plate (122; 222; 322) comprises an upper light guide material layer having a circumferential upper side edge surface and a lower light guide material layer having a circumferential lower side edge surface, wherein the light sources (122; 222; 322) feed backlight (130; 230; 330) into at least a partial area of the upper side edge surface and the at least one proximity sensor system transmitter element (136; 236; 336) feeds sensor radiation into at least a partial area of the lower side edge surface, wherein each light guide plate element serves for deflecting different radiation.

6. The display device according to claim 4, **characterized in that** the light guide plate (122; 222; 322) comprises an upper light guide material layer having a circumferential upper side edge surface and a lower light guide material layer having a circumferential lower side edge surface, wherein the light sources (120; 220; 320) feed backlight (130; 230; 330) into at least a partial area of the lower side edge surface and the at least one proximity sensor system transmitter element (136; 236; 336) feeds sensor radiation into at least a partial area of the upper side edge surface.

7. The display device according to claim 5 or 6, **characterized in that** the two light guide material layers adjoin each other.

8. The display device according to any one of claims 5 to 7, **characterized by** a reflector, reflecting the backlight (130; 230; 330) and the sensor radiation, on the rear side of the lower light guide material layer facing away from the upper light guide material layer, and/or a reflective coating, reflecting the backlight (130; 230; 330) and the sensor radiation, on the rear side of the lower light guide material layer facing away from the upper light guide material layer.

9. The display device according to claim 5 or claims 5 and 7, **characterized by** a reflector, reflecting the sensor radiation, on the rear side of the lower light guide material layer facing away from the upper light guide material layer, or a reflective coating, reflecting the sensor radiation, on the rear side of the lower light guide material layer facing away from the upper light guide material layer, wherein a reflector reflecting the backlight (30; 130; 230) and being transmissive for the sensor radiation is arranged between the two light guide material layers, or a coating reflecting the backlight and transmissive to the sensor radiation is arranged at one of the two sides of the two light guide material layers, which sides face each other.

10. The display device according to claim 6 or 7, **characterized by** a reflector, reflecting the backlight (130; 230; 330), on the rear side of the lower light guide material layer facing away from the upper light guide material layer, or a reflective coating, reflecting the backlight (130; 230; 330), on the rear side of the lower light guide material layer facing away from the upper light guide material layer, wherein a reflector reflecting the sensor radiation and being transmissive for the backlight (130; 230; 330) is arranged between the two light guide material layers, or a coating reflecting the sensor radiation and transmissive to the backlight (130; 230; 330) is arranged at one of the two sides of the two light guide material layers, which sides face each other.

11. A display device, in particular for a vehicle, comprising
- a display (412),
- a backlighting unit (418) for backlighting the display (412),
- wherein the backlighting unit (418) comprises a plurality of light sources for backlight (430) and a light guide plate (422) having a light emission side (428) facing the display (412), an opposite rear side (426) and a circumferential side edge surface (432) arranged between the light emission side (428) and the rear side (426),
- wherein the light sources (420) are arranged next to the light guide plate (422) in a laterally offset manner for feeding light through at least a partial area of the side edge surface (432) of the light guide plate (422) into the latter, and wherein backlight (430) fed into the light guide plate from the side is emitted from the light emission side (428) of the light guide plate (422), and
- a proximity sensor system for sensing an object located in the area in front of the display (412), for example a hand of a person,
- wherein the proximity sensor system comprises at least one proximity sensor system transmitter element (436) for transmitting invisible sensor radiation, in particular IR sensor radiation, and at least one proximity sensor system receiver element (438) for receiving sensor radiation reflected from an object in the area in front of the display (412),
- wherein the at least one proximity sensor system transmitter element (436) is arranged in a manner facing the rear side (426) of the light guide plate (422) and feeds sensor radiation into the light guide plate (422) therethrough, and
- a reflector (424) reflecting the backlight (430) and being transmissive for the sensor radiation on the rear side (426) of the light guide plate (422), or a coating reflecting the backlight (430) and being transmissive for the sensor radiation on the rear side of the light guide plate (422), **characterized in that**
- the at least one proximity sensor system receiver element (438) is arranged between the display (412) and the light guide plate (422) and/or opposite to the rear side (26) of the light guide plate (422).

12. The display device according to claim 11, **characterized in that** the light guide plate (522) comprises an upper light guide material layer having a circumferential upper side edge surface and a lower light guide material layer having a circumferential lower side edge surface, wherein the light sources (520) feed backlight (530) into at least a partial area of the one, e.g. the upper side edge surface, and the at least one proximity sensor system transmitter element (536) feeds sensor radiation into at least a partial area of the rear side of the lower light guide material layer facing away from the upper light guide material layer, and that a reflector reflecting the backlight (530) and transmissive to the sensor radiation is arranged between the two light guide material layers, or a coating reflecting the backlight (530) and being transmissive for the sensor radiation is arranged at one of the two sides of the two light guide material layers, which sides face each other.

13. The display device according to any one of claims 1 to 12, **characterized in that** the light guide plate (22; 122; 222; 322; 422; 522) is of an optically diffuse configuration at least for the backlight (30; 130; 230; 330; 430; 530) and preferably also for the sensor radiation.

14. The display device according to any one of claims 1 to 13, **characterized by** an optical diffuser between the light emission side of the light guide plate (22; 122; 222; 322; 422; 522) and the display (12; 112; 212; 312; 412; 512) for further homogenizing the backlight (30; 130; 230; 330; 430; 530) and possibly the sensor radiation.

15. The display device according to any one of claims 1 to 14, **characterized in that** the display is provided with a touch sensor system.

## Revendications

1. Dispositif d'affichage, en particulier pour un véhicule, doté
- d'un écran (12),
- d'une unité de rétroéclairage (18) destinée à rétroéclairer l'écran (12),
- dans lequel l'unité de rétroéclairage (18) comporte plusieurs sources lumineuses (20) pour la lumière de rétroéclairage (30) et une plaque conductrice de lumière (22) dotée d'une face de sortie de lumière (28) tournée vers l'écran (12), d'une face arrière (26) opposée à celle-ci et d'une surface de bord latéral (32) périphérique disposée entre la face de sortie de lumière (28) et la face arrière (26),
- dans lequel les sources lumineuses (20) sont, à des fins d'injection de lumière par au moins une zone de partielle de la surface de bord latéral (32) de la plaque conductrice de lumière (22) dans celle-ci, disposées de manière décalée latéralement à côté de la plaque conductrice de lumière (22) et la lumière de rétroéclairage (30) injectée latéralement dans la plaque conductrice de lumière (22) sort de la face de sortie de lumière (28) de la plaque conductrice de lumière (22) et
- de capteurs de proximité (34) destinés à détecter un objet se trouvant dans la zone devant l'écran (12) comme par exemple une main d'une personne,
- dans lequel les capteurs de proximité (34) comportent au moins un élément émetteur (36) destiné à l'émission de rayonnement de détection non-visible, en particulier un rayonnement IR, et au moins un élément récepteur (38) destiné à la réception du rayonnement de détection réfléchi par un objet se trouvant dans la zone devant l'écran (12) et
- dans lequel l'au moins un élément émetteur (36) des capteurs de proximité est disposé en décalage latéral par rapport à une zone de la surface de bord latéral (32) de la plaque conductrice de lumière (22) et le rayonnement de détection, dans cette même zone, est injecté dans la surface de bord latéral (32) de la plaque conductrice de lumière (22) et sort de la face de sortie de lumière (28) de la plaque conductrice de lumière (22),
**caractérisé**
- **en ce que** l'au moins un élément récepteur (38) des capteurs de proximité est disposé entre l'écran (12) et la plaque conductrice de lumière (22) et/ou à l'opposé de la face arrière (26) de la plaque conductrice de lumière (22).

2. Dispositif d'affichage selon la revendication 1, **caractérisé en ce que** l'au moins un élément émetteur (36) des capteurs de proximité est disposé entre les sources lumineuses (20) de l'unité de rétroéclairage (18).

3. Dispositif d'affichage selon la revendication 1 ou 2, **caractérisé en ce qu'**un réflecteur (24) réfléchissant la lumière de rétroéclairage (30) et le rayonnement de détection est disposé sur la face arrière (26) de la plaque conductrice de lumière (22) ou **en ce que** la face arrière (26) de la plaque conductrice de lumière (22) comporte un revêtement réflecteur réfléchissant la lumière de rétroéclairage (30) ou le rayonnement de détection.

4. Dispositif d'affichage selon la revendication 1, **caractérisé en ce que** l'au moins un élément émetteur (136 ; 236 ; 336) des capteurs de proximité est positionné en-dessous et/ou au-dessus du plan où sont disposés les sources lumineuses (120 ; 220 ; 320).

5. Dispositif d'affichage selon la revendication 4, **caractérisé en ce que** la plaque conductrice de lumière (122 ; 222 ; 322) comprend une couche supérieure de matériau conducteur de lumière dotée d'une surface de bord latéral supérieure périphérique et une couche inférieure de matériau conducteur de lumière dotée d'une surface de bord latéral inférieure périphérique, dans lequel les sources lumineuses (122 ; 222 ; 322) injectent la lumière de rétroéclairage (130 ; 230 ; 330) dans au moins une zone partielle de la surface de bord latéral supérieure et l'au moins un élément émetteur (136 ; 236 ; 336) des capteurs de proximité injecte le rayonnement de détection dans au moins une zone partielle de la surface de bord latéral inférieure, dans lequel chaque élément de plaque conductrice de lumière sert à dévier différents rayonnements.

6. Dispositif d'affichage selon la revendication 4, **caractérisé en ce que** la plaque conductrice de lumière (122 ; 222 ; 322) comprend une couche supérieure de matériau conducteur de lumière dotée d'une surface de bord latéral supérieure périphérique et une couche inférieure de matériau conducteur de lumière dotée d'une surface de bord latéral inférieure périphérique, dans lequel les sources lumineuses (120 ; 220 ; 320) injectent la lumière de rétroéclairage (130 ; 230 ; 330) dans au moins une zone partielle de la surface de bord latéral inférieure et l'au moins un élément émetteur (136 ; 236 ; 336) des capteurs de proximité injecte le rayonnement de détection dans au moins une zone partielle de la surface de bord latéral supérieure.

7. Dispositif d'affichage selon la revendication 5 ou 6, **caractérisé en ce que** les deux couches de matériau conducteur de lumière sont contiguës.

8. Dispositif d'affichage selon l'une des revendications 5 à 7, **caractérisé par** un réflecteur réfléchissant la lumière de rétroéclairage (130 ; 230 ; 330) et le rayonnement de détection sur la face arrière de la couche inférieure de matériau conducteur de lumière se détournant de la couche supérieure de matériau conducteur de lumière et/ou un revêtement réflecteur réfléchissant la lumière de rétroéclairage (130 ; 230 ; 330) et le rayonnement de détection sur la face arrière de la couche inférieure de matériau conducteur de lumière se détournant de la couche supérieure de matériau conducteur de lumière.

9. Dispositif d'affichage selon la revendication 5 ou les revendications 5 et 7, **caractérisé par** un réflecteur réfléchissant le rayonnement de détection sur la face arrière de la couche inférieure de matériau conducteur de lumière se détournant de la couche supérieure de matériau conducteur de lumière ou un revêtement réflecteur réfléchissant le rayonnement de détection sur la face arrière de la couche inférieure de matériau conducteur de lumière se détournant de la couche supérieure de matériau conducteur de lumière, dans lequel un réflecteur réfléchissant la lumière de rétroéclairage (130 ; 230 ; 330) et transparent pour le rayonnement de détection est disposé entre les deux couches de matériau conducteur de lumière ou un revêtement réfléchissant la lumière de rétroéclairage et transparent pour le rayonnement de détection est disposé sur une deux faces tournées l'une vers l'autre des deux couches de matériau conducteur de lumière.

10. Dispositif d'affichage selon la revendication 6 ou 7, **caractérisé par** un réflecteur réfléchissant la lumière de rétroéclairage (130 ; 230 ; 330) sur la face arrière de la couche inférieure de matériau conducteur de lumière se détournant de la couche supérieure de matériau conducteur de lumière ou un revêtement réflecteur réfléchissant la lumière de rétroéclairage (130 ; 230 ; 330) sur la face arrière de la couche inférieure de matériau conducteur de lumière se détournant de la couche supérieure de matériau conducteur de lumière, dans lequel un réflecteur réfléchissant le rayonnement de détection et transparent pour la lumière de rétroéclairage (130 ; 230 ; 330) est disposé entre les deux couches de matériau conducteur de lumière ou un revêtement réfléchissant le rayonnement de détection et transparent pour la lumière de rétroéclairage est disposé sur une deux faces tournées l'une vers l'autre des deux couches de matériau conducteur de lumière.

11. Dispositif d'affichage, en particulier pour un véhicule, doté
- d'un écran (412),
- d'une unité de rétroéclairage (418) destinée à rétroéclairer l'écran (412),
- dans lequel l'unité de rétroéclairage (418) comporte plusieurs sources lumineuses pour la lumière de rétroéclairage (430) et une plaque conductrice de lumière (422) dotée d'une face de sortie de lumière (428) tournée vers l'écran (412), d'une face arrière (426) opposée à celle-ci et d'une surface de bord latéral (432) périphérique disposée entre la face de sortie de lumière (428) et la face arrière (426),
- dans lequel les sources lumineuses (420) sont, à des fins d'injection de lumière par au moins une zone de partielle de la surface de bord latéral (432) de la plaque conductrice de lumière (422) dans celle-ci, disposées de manière décalée latéralement à côté de la plaque conductrice de lumière et la lumière de rétroéclairage (430) injectée latéralement dans la plaque conductrice de lumière sort de la face de sortie de lumière (428) de la plaque conductrice de lumière (422),
- de capteurs de proximité destinés à détecter un objet se trouvant dans la zone devant l'écran (412) comme par exemple une main d'une personne,
- dans lequel les capteurs de proximité comportent au moins un élément émetteur (436) destiné à l'émission de rayonnement de détection non-visible, en particulier un rayonnement IR, et au moins un élément récepteur (438) destiné à la réception du rayonnement de détection réfléchi par un objet se trouvant dans la zone devant l'écran (412),
- dans lequel l'au moins un élément émetteur (436) des capteurs de proximité est tourné vers la face arrière (426) de la plaque conductrice de lumière (422) et injecte par celle-ci le rayonnement de détection dans la plaque conductrice de lumière (422) et
- d'un réflecteur (424) réfléchissant la lumière de rétroéclairage (430) et transparent pour le rayonnement de détection sur la face arrière (426) de la plaque conductrice de lumière (422) ou d'un revêtement réfléchissant la lumière de rétroéclairage (430) et transparent pour le rayonnement de détection sur la face arrière de la plaque conductrice de lumière (422),
**caractérisé**
- **en ce que** l'au moins un élément récepteur (438) des capteurs de proximité est disposé entre l'écran (412) et la plaque conductrice de lumière (422) et/ou à l'opposé de la face arrière (26) de la plaque conductrice de lumière (422).

12. Dispositif d'affichage selon la revendication 11, **caractérisé en ce que** la plaque conductrice de lumière (522) comprend une couche supérieure de matériau conducteur de lumière dotée d'une surface de bord latéral supérieure périphérique et une couche inférieure de matériau conducteur de lumière dotée d'une surface de bord latéral inférieure périphérique, dans lequel les sources lumineuses (520) injectent de la lumière de rétroéclairage (530) dans au moins une zone de partielle de l'une surface de bord latéral, par exemple la surface supérieure et l'au moins un élément émetteur (536) des capteurs de proximité injecte du rayonnement de détection dans au moins une zone partielle de la face arrière de la couche inférieure de matériau conducteur de lumière se détournant de la couche supérieure de matériau conducteur de lumière, et **en ce qu'**un réflecteur réfléchissant la lumière de rétroéclairage (530) et transparent pour le rayonnement de détection est disposé entre les deux couches de matériau conducteur de lumière ou un revêtement réfléchissant la lumière de rétroéclairage (530) et transparent pour le rayonnement de détection est disposé sur une deux faces tournées l'une vers l'autre des deux couches de matériau conducteur de lumière.

13. Dispositif d'affichage selon l'une des revendications 1 à 12, **caractérisé en ce que** la plaque conductrice de lumière (22 ; 122 ; 222 ; 322 ; 422 ; 522) est réalisée comme optiquement diffusante au moins pour la lumière de rétroéclairage (30 ; 130 ; 230 ; 330 ; 430 ; 530) et de préférence également pour le rayonnement de détection.

14. Dispositif d'affichage selon l'une des revendications 1 à 13, **caractérisé par** un diffuseur optique entre la face de sortie de lumière de la plaque conductrice de lumière (22 ; 122 ; 222 ; 322 ; 422 ; 522) et l'écran (12 ; 112 ; 212 ; 312 ; 412 ; 512) destiné à homogénéiser ultérieurement la lumière de rétroéclairage (30 ; 130 ; 230 ; 330 ; 430 ; 530) et éventuellement le rayonnement de détection.

15. Dispositif d'affichage selon l'une des revendications 1 à 14, **caractérisé en ce que** l'écran est prévu doté de capteurs tactiles.
